# EUROPÄISCHE PATENTSCHRIFT

(11) **EP 1 038 354 B1**
(45) Veröffentlichungstag und Bekanntmachung des Hinweises auf die Patenterteilung: **10.09.2003**
(21) Anmeldenummer: 98961226.2
(22) Anmeldetag: 21.11.1998
(51) Int. Cl.: H03K 17/945

(54) **SCHALTUNGSANORDNUNG ZUR ÜBERWACHUNG DES FEHLERFREIEN UND/ODER ZUR ERKENNUNG EINES FEHLERBEHAFTETEN ZUSTANDS EINER ANLAGE**
CIRCUIT FOR MONITORING TROUBLE-FREE STATE AND/OR DETECTING INCORRECT STATE OF AN INSTALLATION
CIRCUIT SERVANT A VERIFIER QUE L'ETAT D'UNE INSTALLATION EST CORRECT ET/OU A RECONNAITRE UN ETAT INCORRECT DE CETTE INSTALLATION

(30) Priorität: 26.11.1997 DE 19752362
(43) Veröffentlichungstag der Anmeldung: 27.09.2000
(73) Patentinhaber: i f m electronic gmbh, D-45127 Essen (DE); Doppelmayr Seilbahn-Vertriebs-GmbH., 6961 Wolfurt (AT)
(72) Erfinder: ALBRICH, Reinhard, A-6850 Dornbirn (AT); HERRMANN, Karl, D-88239 Haslach (DE); LAMARCHE, Jean-Luc, F-67206 Mittelhausbergen (FR); STROBEL, Manfred, D-88250 Weingarten (DE)
(74) Vertreter: Gesthuysen, von Rohr & Eggert
(86) Internationale Anmeldenummer: EP9807488
(87) Internationale Veröffentlichungsnummer: WO99027649

(56) Entgegenhaltungen:
- EP-A- 0 809 361
- DE-A- 3 219 270
- US-A- 4 271 763
- US-A- 5 187 723
- US-A- 5 581 180

## Beschreibung

Die Erfindung betrifft eine Schaltungsanordnung zur Überwachung des fehlerfreien und/oder zur Erkennung eines fehlerbehafteten Zustandes einer Seilbahn- oder Sesselliftanlage gemäß dem Oberbegriff des Patentanspruchs 1.

Anlagen der verschiedensten Art, insbesondere sogenannte sicherheitsrelevante Anlagen, bedürfen häufig der ständigen Kontrolle, d. h. es bedarf der Überwachung des fehlerfreien Zustands und - in der Regel in Verbindung mit der Überwachung des fehlerfreien Zustands - der Erkennung eines fehlerbehafteten Zustands. Sobald ein fehlerbehafteter Zustand erkannt worden ist, wird eine sicherheitsrelevante Maßnahme eingeleitet.

Bei Seilbahn- und Sesselliftanlagen ist als sicherheitsrelevantes Kriterium die Lage des Seiles relativ zu den das Seil tragenden bzw. das Seil führenden Seilrollen zu kontrollieren. Entspricht die Ist-Lage des Seiles relativ zu mindestens einer Seilrolle nicht der Soll-Lage, so müssen sicherheitsrelevante Maßnahmen ergriffen werden. Bei einer geringen Abweichung zwischen der Ist-Lage des Seiles und seiner Soll-Lage kann die daraus abgeleitete sicherheitsrelevante Maßnahme eine Reduzierung der Seilgeschwindigkeit sein. Überschreitet die Abweichung zwischen der Ist-Lage des Seiles und der Soll-Lage einen vorgegebenen Grenzwert, so besteht die sicherheitsrelevante Maßnahme jedenfalls darin, daß die Seilbahnanlage bzw. die Sesselliftanlage augenblicklich stillgesetzt wird.

Bei elektrischen - und heute natürlich auch bei elektronischen - Schaltungen, die als Steuerschaltungen funktionieren, unterscheidet man zwischen dem Arbeitsstromprinzip und dem Ruhestromprinzip. Beim Arbeitsstromprinzip wird - z. B. in eine Anlage - dann steuernd eingegriffen, wenn in der Steuerschaltung ein - hinreichend großer - Steuerstrom fließt. In nach dem Arbeitsstromprinzip arbeitenden Steuerschaltungen vorhandene Schaltgeräte sind als Schließer ausgeführt; sie sind elektrisch leitend, wenn sie betätigt sind. Im Gegensatz dazu wird beim Ruhestromprinzip - z. B. in eine Anlage - dann steuernd eingegriffen, wenn in der Steuerschaltung kein Steuerstrom fließt. In nach dem Ruhestromprinzip arbeitenden Steuerschaltungen vorhandene Schaltgeräte sind als Öffner ausgeführt; sie sind elektrisch nicht-leitend, wenn sie betätigt sind.

Bei nach dem Arbeitsstromprinzip aufgebauten Steuerschaltungen wird, wie zuvor ausgeführt, nur dann in eine zugeordnete Anlage steuernd eingegriffen, wenn in der Steuerschaltung ein - hinreichend großer - Steuerstrom fließt. Voraussetzung dafür ist also, daß einerseits die notwendige Betriebsspannung vorhanden ist, daß andererseits kein Leitungsbruch vorliegt und daß schließlich das in einer solchen Steuerschaltung vorhandene, als Schließer ausgeführte Schaltgerät funktionstüchtig ist Im Gegensatz dazu wird bei einer nach dem Ruhestromprinzip arbeitenden Steuerschaltung dann in eine dazu gehörende Anlage steuernd eingegriffen, wenn in der Steuerschaltung kein Steuerstrom fließt.

Die zuvor gemachten Ausführungen zum Arbeitsstromprinzip und zum Ruhestromprinzip machen deutlich, daß Steuerschaltungen, die sicherheitsrelevante Maßnahmen auslösen sollen, nach dem Ruhestromprinzip arbeiten müssen. Da dabei der stromlose Zustand in der Steuerschaltung so ausgewertet wird, daß die entsprechende Anlage im sicheren Zustand ist, führt ein Ausfall der Betriebsspannung und ein Leitungsbruch stets dazu, daß die Anlage, falls sie sich nicht im sicheren Zustand befindet, in den sicheren Zustand gebracht wird. Bei einer Seilbahnanlage bzw. bei einer Sesselliftanlage ist der sichere Zustand natürlich der abgeschaltete Seilantrieb.

Bei den nach dem Arbeitsstromprinzip funktionierenden Steuerschaltungen, also bei Steuerschaltungen, bei denen die Schaltgeräte als Schließer ausgeführt sind, sind die Schaltgeräte parallelgeschaltet; nach dem Betätigen eines als Schließer ausgeführten Schaltgerätes wird die Steuerschaltung insgesamt wirksam. Demgegenüber sind bei nach dem Ruhestromprinzip funktionierenden Steuerschaltungen, also bei Steuerschaltungen, bei denen die Schaltgeräte als Öffner ausgeführt sind, die Schaltgeräte in Serie geschaltet; nach dem Betätigen eines als Öffner ausgeführten Schaltgerätes wird die Steuerschaltung stromlos und damit insgesamt wirksam.

Aus der US -A- 5,487,448 ist eine eingangs beschriebene Schaltungsanordnung in Form einer Überwachungseinrichtung für eine Steuervorrichtung bekannt, die eine Mehrzahl von miteinander verbundenen Näherungsschaltern aufweist, wobei die einzelnen Näherungsschalter die ordnungsgemäße Position eines Aufzuges überwachen.

Damit nun bei einer Schaltungsanordnung der in Rede stehenden Art dann, wenn durch die Serienschaltung aller Näherungsschalter ein fehlerhafter Zustand der Anlage erkannt worden ist, der Fehler lokalisiert werden kann, ist - wie bei der aus der US -A- 5,487,448 bekannten Überwachungseinrichtung - vorgesehen, daß die Näherungsschalter hinsichtlich ihres Zustandes, insbesondere hinsichtlich ihres Schaltzustandes abfragbar sind.

Aus der US -A- 5,581,180 ist ein Verschiebungsdetektor und eine Überwachungsanordnung für Liftanlagen bekannt, bei der der einen Hallsensor aufweisende Verschiebungsdetektor ein dem Verschiebungsgrad des zu überwachenden Seils proportionales analoges Ausgangssignal liefert. In Abhängigkeit vom Verschiebungsgrad des Seils relativ zu einer vorgegebenen Position wird die Geschwindigkeit des Motors der Liftanlage gesteuert, wobei ab einem bestimmten Wert des Verschiebungsgrads der Motor vollständig gestoppt wird.

Wie bei einer Schaltungsanordnung der beschriebenen Art die Näherungsschalter im einzelnen ausgebildet sind, hängt vor allem davon ab, wie die Anlage im einzelnen ausgeführt ist, bei der mit Hilfe dieser Schaltungsanordnung der fehlerfreie Zustand überwacht und ein fehlerbehafteter Zustand erkannt werden soll. Handelt es sich bei dieser Anlage um eine Seilbahn- oder Sesselliftanlage, so ist nach der nachveröffentlichten EP -A- 0 809 361 vorgesehen, daß jedes Überwachungs- und Erkennungsgerät drei Anwesenheitsindikatoren aufweist und die Anwesenheitsindikatoren ausgangsseitig - direkt oder indirekt - miteinander logisch verknüpft sind. Problematisch ist hierbei der durch die drei Sensoren benötigte erhöhte Platzbedarf, der häufig nicht zur Verfügung steht.

Der vorliegenden Erfindung liegt die Aufgabe zu Grunde, eine Schaltungsanordnung der beschriebenen Art so auszugestalten, daß die Überwachung besonders hohe Sicherheitsanforderungen erfüllt und auch bei nur geringem vorhandenen Einbauraum einsetzbar ist.

Die zuvor hergeleitete und aufgezeigte Aufgabe ist nun zunächst und im wesentlichen dadurch gelöst, daß jeder Näherungsschalter mehrere unterschiedliche räumliche Beeinflussungsbereiche und mehrere Signalausgänge aufweist. Dabei wird im Rahmen der Erfindung unter Beeinflussungsbereich derjenige räumliche Bereich im Abstand zum Näherungsschalter verstanden, innerhalb dessen das Vorhandensein bzw. das Nichtvorhandensein eines überwachten Gegenstandes bei dem Näherungsschalter zu einer Zustandsänderung führt. Bei einem gewöhnlichen Näherungsschalter ist der Beeinflussungsbereich der Bereich über der aktiven Fläche des Näherungsschalters, in dem der Näherungsschalter auf die Näherung von bedämpfendem Material reagiert, d. h. ein gewöhnlicher Näherungsschalter weist genau einen Beeinflussungsbereich auf.

Dadurch, daß erfindungsgemäß jeder Näherungsschalter mehrere räumlich unterschiedliche Beeinflussungsbereiche aufweist, ist eine genaue und selektive Überwachung des Zustandes der Anlage möglich. Somit kann nicht nur zwischen einem fehlerfreien und einem fehlerhaften Zustand unterschieden werden, sondern es kann zusätzlich die Verschlechterung des fehlerfreien Zustandes erkannte werden und somit durch Einleitung von entsprechenden Maßnahmen das Eintreten eines fehlerhaften Zustandes möglicherweise vermieden werden. Bei der Überwachung der Lage des Seiles einer Seilbahn- oder Sesselliftanlage relativ zu den das Seil führenden Seilrollen kann somit das seitliche Verrutschen des Seiles erkannt werden.

Bei einer bevorzugten Ausführungsform der Erfindung weisen die Näherungsschalter einen Steuereingang und einen Steuerausgang auf, wobei der Steuerausgang des (n-1)-ten Näherungsschalters mit dem Steuereingang des n-ten Näherungsschalters verbunden ist. Dadurch ist einerseits die aus Sicherheitsgründen notwendige Serienschaltung der Näherungsschalter verwirklicht, wird andererseits eine Aufaddierung der Spannungsabfälle an den Näherungsschaltern verhindert. Der Steuereingang des ersten Näherungsschalters ist mit der Steuer- und Auswerteeinheit verbunden und wird von dieser mit einem getakteten, vorzugsweise zyklisch umprogrammierten Signal beaufschlagt.

Nach einer weiteren Lehre der Erfindung sind bei der erfindungsgemäßen Schaltungsanordnung die Näherungsschalter nicht nur hinsichtlich ihres Zustandes, insbesondere ihres Schaltzustandes, abfragbar, sondern zusätzlich adressierbar. Damit ist gemeint, daß jeder einzelne Näherungsschalter dadurch individualisiert ist, daß ihm eine bestimmte Adresse zugeordnet ist. Für das Abfragen des Zustands eines bestimmten Näherungsschalters wird also der durch seine Adresse individualisierte Näherungsschalter "angesprochen" und dann sein Zustand, bei einer Ausführung als Schaltgerät sein Schaltzustand, abgefragt. Dabei bilden die Näherungsschalter und die Steuer- und Auswerteeinheit hinsichtlich der Abfrage- und Adressiermöglichkeit-über entsprechende Verbindungsleitungen - einen Ring.

Vorteilhafterweise werden die Adressen und Informationen über die Verbindungsleitungen nur in eine Richtung übertragen, und zwar entgegen der Übertragungsrichtung des von der Steuer- und Auswerteeinheit in den Steuereingang des ersten Näherungsschalters eingespeisten getakteten Signals. Somit kann der Ausfall eines Näherungsschalters oder der Bruch eines Übertragungskabels erkannt werden

Nach einer bevorzugten Ausgestaltung der Erfindung ist zusätzlich einer der Beeinflussungsbereiche für sich in zwei Teilbereiche unterteilt, wobei die Unterteilung in die beiden Teilbereiche senkrecht zur Unterteilung in die Beeinflussungsbereiche verläuft. Hierdurch kann zusätzlich zu dem seitlichen Verrutschen eines Seiles einer Seilbahn- oder Sesselliftanlage relativ zu den das Seil führenden Seilrollen auch eine hierzu senkrecht Veränderung der Seillage erfaßt werden. Zu einer solchen Veränderung der Seillage kann es beispielsweise kommen, wenn die Seilrollen durch Belastung selber ihre Position verändern oder wenn es zu einer Abnutzung der Laufflächen der Seilrollen kommt.

Im einzelnen gibt es nun verschiedene Möglichkeiten, die erfindungsgemäße Schaltungsanordnung auszugestalten und weiterzubilden. Solche Ausgestaltungen und Weiterbildungen ergeben sich aus den dem Patentanspruch 1 nachgeordneten Patentansprüchen und aus der folgenden Beschreibung eines Ausführungsbeispiels in Verbindung mit der Zeichnung. In der Zeichnung zeigt
- Fig. 1: schematisch, einen Ausschnitt aus einer Seilbahn- oder Sesselliftanlage, bei der die erfindungsgemäße Schaltungsanordnung eingesetzt ist,
- Fig. 2: schematisch, ein bevorzugtes Ausführungsbeispiel einer erfindungsgemäßen Schaltungsanordnung,
- Fig. 3: eine Prinzipskizze der unterschiedlichen Beeinflussungsbereiche eines Näherungsschalters bei einer erfindungsgemäßen Schaltungsanordnung.

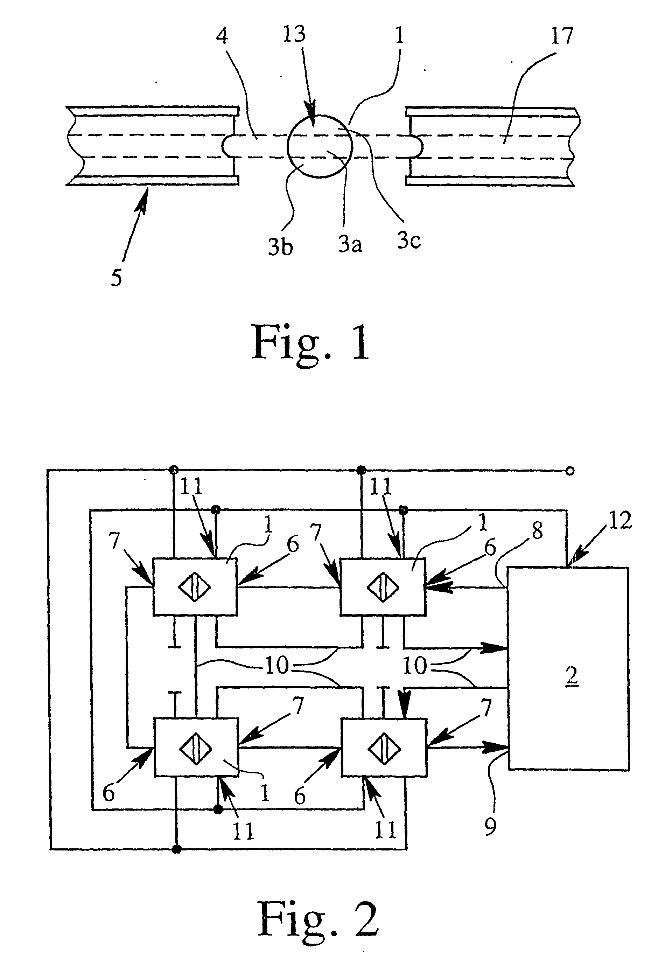

Die in Fig. 2 dargestellte Schaltungsanordnung ist bestimmt zur Überwachung des fehlerfreien und zur Erkennung eines fehlerhaften Zustandes einer Anlage, z. B. einer in Fig. 1 schematisch und nur ausschnittsweise dargestellten Seil- oder Sesselliftanlage, und besteht in ihrem grundsätzlichen Aufbau aus einer Mehrzahl von Näherungsschaltern 1 und aus einer Steuer- und Auswerteeinheit 2. Die Näherungsschalter 1 sind miteinander und mit der Steuer- und Auswerteeinheit 2 in Serie geschaltet.

In Fig. 1 ist angedeutet, daß jeder Näherungsschalter 1 drei unterschiedliche räumlich Beeinflussungsbereiche 3a, 3b, 3c aufweist, wobei die drei Beeinflussungsbereiche 3a, 3b, 3c in erster Linie senkrecht zur Längsrichtung des Seiles 4 nebeneinander wirksam sind. Es können nun folgende Situationen auftreten:
1. Die Ist-Lage des Seiles 4 entspricht, wie in Fig. 1 eingezeichnet, der Soll-Lage. Dann befindet sich das Seil 4 im Beeinflussungsbereich 3a, und der zu dem Beeinflussungsbereich 3a korrespondierende Signalausgang wird also durchgeschaltet.
2. Die Ist-Lage des Seiles 4 entspricht nicht mehr der Soll-Lage.
   2.a) Das Seil 4 befindet sich links von der in Fig. 1 eingezeichneten Soll-Lage und somit im Beeinflussungsbereich 3b. Der zu dem Beeinflussungsbereich 3b korrespondierende Signalausgang wird also durchgeschaltet.
   2.b) Das Seil 4 befindet sich rechts von der in Fig. 1 eingezeichneten Soll-Lage und somit im Beeinflussungsbereich 3c. Der zu dem Beeinflussungsbereich 3c korrespondierende Signalausgang wird also durchgeschaltet.
   2.c) Das Seil 4 befindet sich rechts oder links außerhalb der Seilrollen 5 und damit außerhalb der Beeinflussungsbereiche 3a, 3b und 3c.

Mit diesen Voraussetzungen gilt folgendes:

Sind der zu dem Beeinflussungsbereich 3a korrespondierende Signalausgang durchgeschaltet, die beiden anderen Signalausgänge jedoch nicht, so bedeutet dies, daß sich das Seil in seiner Ist-Lage befindet. Die Seilbahn- oder Sesselliftanlage kann in der normalen Geschwindigkeit betrieben werden.

Sind der zu dem Beeinflussungsbereich 3a korrespondierende Signalausgang und zusätzlich der zu dem Beeinflussungsbereich 3b oder 3c korrespondierende Signalausgang durchgeschaltet, so ist das ein Kriterium dafür, daß die Ist-Lage des Seiles 4 nicht mehr exakt mit der Soll-Lage übereinstimmt. Hier kann es ausreichend sein, wenn die Seilbahn- oder Sesselliftanlage mit leicht verringerter Geschwindigkeit betrieben wird.

Ist nur der zu dem Beeinflussungsbereich 3b oder 3c korrespondierende Signalausgang durchgeschaltet, so ist das ein Kriterium dafür, daß die Ist-Lage des Seiles 4 schon erheblich von der Soll-Lage abweicht.

Sind alle drei Signalausgänge durchgeschaltet, so ist das ein nicht definierter Zustand. In diesem Fall muß die Schaltungsanordnung sofort eingreifen.

Ist keiner der drei Signalausgänge durchgeschaltet, so ist das ein sicherheitsrelevantes Kriterium und die Schaltungsanordnung muß sofort eingreifen. Bei einer Seilbahnoder Sesselliftanlage würde dies bedeuten, daß das Seil 4 aus der Seilrolle 5 herausgesprungen ist und sofort die Seilbahn- oder Sesselliftanlage stillgelegt werden muß.

In Fig. 2 sind nur vier Näherungsschalter 1 dargestellt. In der Regel gehört jedoch zu der erfindungsgemäßen Schaltungsanordnung eine Vielzahl von Näherungsschaltern 1, bei einer Schaltungsanordnung zur Überwachung des fehlerfreien und zur Erkennung eines fehlerbehafteten Zustands einer Seilbahn- oder Sesselliftanlage können ohne weiteres - über mehrere hundert Meter verteilt - fünfzig oder mehr Näherungsschalter 1 erforderlich sein.

Die Näherungsschalter 1 weisen jeweils einen Steuereingang 6 und einen Steuerausgang 7 auf, wobei der Steuerausgang 7 des ersten Näherungsschalters 1 mit den Steuereingang 6 des zweiten Näherungsschalters 1, der Steuerausgang 7 des zweiten Näherungsschalters 1 mit den Steuereingang 6 des dritten Näherungsschalters 1 und der Steuerausgang 7 des dritten Näherungsschalters 1 mit den Steuereingang 6 des vierten Näherungsschalters 1 verbunden ist Der Steuereingang 6 des ersten Näherungsschalters 1 ist mit dem Steuerausgang 8 der Steuer- und Auswerteeinheit 2 verbunden und wird von dieser mit einem getakteten, vorzugsweise zyklischen umprogrammierten Signal beaufschlagt. Der Steuerausgang 7 des vierten Näherungsschalters 1 ist mit dem Steuereingang 9 der Steuer- und Auswerteeinheit 2 verbunden. Durch diese serielle Verbindung der einzelnen Näherungsschalter 1 wird die Signalleitung der Schaltungsanordnung gebildet, über die die einzelnen Näherungsschalter 1 die sicherheitsrelevanten Signale an die Steuer- und Auswerteeinheit 2 senden.

Für das in Fig. 2 dargestellte Ausführungsbeispiel einer erfindungsgemäßen Schaltungsanordnung gilt nun weiter, daß die Näherungsschalter 1 und die Steuer- und Auswerteeinheit 2 hinsichtlich der Abfrage- und Adressiermöglichkeit - über entsprechende Verbindungsleitungen 10 - einen Ring bilden. Dabei werden die Adressen und Informationen über die Verbindungsleitungen 10 nur in eine Richtung, und zwar entgegen der Übertragungsrichtung des getakteten Signals übertragen, welches am Steuerausgang 8 der Steuer- und Auswerteeinheit 2 auf den Steuereingang 6 des ersten Näherungsschalters 1 gegeben wird, also entgegen der Übertragungsrichtung der sicherheitsrelevanten Signale auf der Signalleitung. Dadurch ist sichergestellt, daß die Steuer- und Auswerteeinheit 2 nicht nur eine Unterbrechung der Verbindung zwischen einem der Näherungsschalter 1 bemerkt, sondern auch den Ort des Fehlers feststellt. Ist beispielsweise die Signalleitung zwischen zwei Näherungsschaltern 1 unterbrochen, so wird dies zwar von der Steuer- und Auswerteeinheit 2 dadurch bemerkt, daß an ihrem Steuereingang 9 kein Signal über die Signalleitung ankommt, wo sich der Fehler befindet, kann so jedoch nicht festgestellt werden. Dadurch, daß die Adressierung über die Verbindungsleitungen 10 jedoch in entgegengesetzter Richtung zur Übertragungsrichtung der Signalleitung erfolgt, kann über ein sukzessives Abfragen der einzelnen Näherungsschalter 1 über die Verbindungsleitung 10 und das über die Signalleitung erhaltene Schaltsignal des angesprochenen Näherungsschalters 1 festgestellt werden, hinter welchem Näherungsschalter 1 der Fehlerort liegt.

Ist beispielsweise bei der in Fig. 2 dargestellten Schaltungsanordnung die Signalleitung zwischen dem zweiten und dritten Näherungsschalter 1 unterbrochen, so beginnt die Steuer- und Auswerteeinheit 2 damit über die Verbindungsleitung 10 zunächst den vierten Näherungsschalter 1 abzufragen. Von diesem erhält die Steuerund Auswerteeinheit 2 über die Signalleitung ein Signal zurück und weiß somit, daß die Verbindung von der Steuer- und Auswerteeinheit 2 zum vierten Näherungsschalter 1 und der vierte Näherungsschalter 1 selber fehlerfrei ist Ebenso erhält die Steuer- und Auswerteeinheit 2 anschließend ein Signal von dem dritten Näherungsschalter 1 zurück. Wird dann jedoch der zweite Näherungsschalter 1 über die Verbindungsleitung 10 abgefragt, so erhält die Steuer- und Auswerteeinheit 2 keine Rückmeldung, da sie unterbrochen ist. Somit ist eine Fehlerlokalisation durch die Steuerund Auswerteeinheit 2 möglich.

Bei der Ausführung der Schaltungsanordnung in Fig. 2 können die Näherungsschalter 1 nur dann Adressen und Informationen über die Verbindungsleitungen 10 empfangen, wenn an ihnen ein Freigabesignal anliegt, welches über Freigabesignaleingänge 11 an den Näherungsschaltern 1 empfangen werden kann. Die Freigabesignaleingänge 11 aller Näherungsschalter 1 sind mit einem Freigabesignalausgang 12 der Steuer- und Auswerteeinheit 2 verbunden.

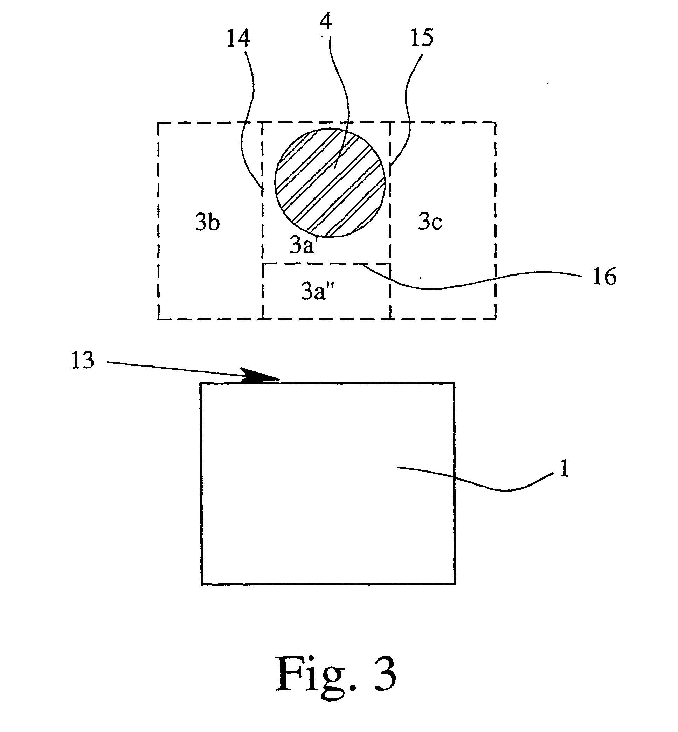

In Fig. 3 ist eine Prinzipskizze der unterschiedlichen Beeinflussungsbereiche eines bevorzugten Näherungsschalters 1 einer erfindungsgemäßen Schaltungsanordnung dargestellt. Der Näherungsschalter 1 ist von der Seite dargestellt, so daß die Aufteilung der sich über der aktiven Fläche 13 des Näherungsschalters 1 befindenden unterschiedlichen räumlichen Beeinflussungsbereiche 3 deutlich wird. Wie in Fig. 1 ist auch hier der sensitive Bereich des Näherungsschalters 1, welcher sich über der aktiven Fläche 13 befindet und der Summe der Beeinflussungsbereiche 3 entspricht, zunächst in drei Beeinflussungsbereiche 3a, 3b und 3c aufgeteilt. Die Grenze 14 zwischen den Beeinflussungsbereichen 3a - 3b einerseits und die Grenze 15 zwischen den Beeinflussungsbereichen 3a - 3c andererseits verlaufen senkrecht zur aktiven Fläche 13 des Näherungsschalters 1. Zusätzlich ist der Beeinflussungsbereich 3a nochmals in zwei Teilbereiche 3a' und 3a" unterteilt, wobei die Grenze 16 zwischen dem Teilbereich 3a' und dem Teilbereich 3a" senkrecht zu den Grenzen 14 bzw. 15 und parallel zur aktiven Fläche 13 verläuft.

Die Näherungsschalter 1 werden bei einer Seilbahn- oder Sesselliflanlage in der Regel ortsfest an den Stützen der Seilbahn- oder Sesselliftanlage, in direkter Nähe zu den das Seil 4 tragenden Seilrollen 5 angebracht. Somit haben sie einen vorgegebenen Abstand zu dem Seil 4, dessen Lage sie überwachen sollen. Durch die Beeinflussungsbereiche 3a, 3b und 3c der Näherungsschalter 1 kann ein seitliches Verrutschen des Seiles 4 relativ zu den Seilrollen 5 festgestellt werden. Durch die Unterteilung des Beeinflussungsbereich 3a in die beiden Teilbereiche 3a' und 3a" kann zusätzlich eine Veränderung des vertikalen Abstandes des Seiles 4 von der aktiven Fläche 13 festgestellt werden. Eine solche Veränderung kann beispielsweise dann auftreten, wenn die Seilrollen 5 durch Belastung selber ihre Position verändern, d. h. nach unten gedrückt werden, oder wenn es zu einer Abnutzung der Laufflächen 17 der Seilrollen 5 kommt.

Selbstverständlich können die in Fig. 3 zur Vereinfachung jeweils gerade verlaufend dargestellten Grenzen 14, 15 und 16 auch eine gebogene Form aufweisen, so daß die Beeinflussungsbereiche 3a, 3b und 3c bzw. die Teilbereiche 3a' und 3a" nicht mehr rechteckige Formen haben, sondern nahezu jede beliebige Form annehmen können.

## Patentansprüche

1. Schaltungsanordnung zur Überwachung des fehlerfreien und/oder zur Erkennung eines fehlerbehafteten Zustands einer Seilbahn- oder Sesselliftanlage, mit einer Mehrzahln von z. B. induktiven oder kapazitiven Näherungsschaltern (1) und mit mindestens einer Steuer- und Auswerteeinheit (2), wobei die Näherungsschalter (1) miteinander und mit der Steuer- und Auswerteeinheit (2) in Serie geschaltet, hinsichtlich ihres Zustandes, insbesondere hinsichtlich ihres Schaltzustandes, abfragbar sind und die Lage des Seils (4) relativ zu den das Seil (4) tragenden bzw. führenden Seilrollen (5) kontrollieren,
**dadurch gekennzeichnet,**
**daß** jeder Näherungsschalter (1) mehrere unterschiedliche räumliche Beeinflussungsbereiche (3) und mehrere Signalausgänge aufweist.

2. Schaltungsanordnung nach Anspruch 1, **dadurch gekennzeichnet, daß** jeder Näherungsschalter (1) einen Steuereingang (6) und einen Steuerausgang (7) aufweist und der Steuerausgang (7) des [n-1]-ten Näherungsschalters (1) mit dem Steuereingang (6) des n-ten Näherungsschalters (1) verbunden ist.

3. Schaltungsanordnung nach Anspruch 2, **dadurch gekennzeichnet, daß** der Steuereingang (6) des ersten Näherungsschalters (1) mit dem Steuerausgang (8) der Steuerund Auswerteeinheit (2) und der Steuerausgang (7) des n-ten Näherungsschalters (1) mit dem Steuereingang (9) der Steuer- und Auswerteeinheit (2) verbunden ist und somit eine Signalleitung vom Steuerausgang (8) über die n Näherungsschalter (1) bis zum Steuereingang (9) der Steuer- und Auswerteeinheit (2) gebildet ist.

4. Schaltungsanordnung nach einem der Ansprüche 1 bis 3, **dadurch gekennzeichnet, daß** die Näherungsschalter (1) adressierbar sind und die Näherungsschalter (1) und die Steuer- und Auswerteeinheit (2) hinsichtlich der Abfrage- und Adressiermöglichkeit - über entsprechende Verbindungsleitungen (10) - einen Ring bilden.

5. Schaltungsanordnung nach Anspruch 4, **dadurch gekennzeichnet, daß** die Adressen und Informationen über die Verbindungsleitungen (10) nur in eine Richtung, und zwar entgegen der Übertragungsrichtung der sicherheitsrelevanten Signale auf der Signalleitung, übertragen werden.

6. Schaltungsanordnung nach einem der Ansprüche 1 bis 5, **dadurch gekennzeichnet, daß** jeder Näherungsschalter (1) mindestens drei unterschiedliche Beeinflussungsbereiche (3a, 3b, 3c) und mindestens drei Signalausgänge aufweist.

7. Schaltungsanordnung nach einem der Ansprüche 1 bis 6, **dadurch gekennzeichnet, daß** jeder Näherungsschalter (1) mindestens einen Beeinflussungsbereich (3a) aufweist, der für sich wiederum in zwei Teilbereiche (3a, 3a") unterteilt ist, wobei die Unterteilung in die beiden Teilbereiche (3a', 3a") senkrecht zur Unterteilung in die Beeinflussungsbereiche (3) verläuft.

8. Schaltungsanordnung nach Anspruch 7, **dadurch gekennzeichnet, daß** sowohl ein seitliches Verrutschen des überwachten Seiles (4) relativ zu den das Seil (4) führenden Seilrollen (5) als auch eine Veränderung der Seillage senkrecht dazu überwacht und detektiert wird.

## Claims

1. Circuit for monitoring the faultless state and/or for detecting the faulty state of a cable railway or chairlift system, with a plurality n of for example inductive or capacitive proximity switches (1) and with at least one control and evaluation unit (2), wherein the proximity switches (1) being series-connected to one another and to the control and evaluation unit (2), can be interrogated with respect to their state, especially with respect to their operating state, and monitor the position of the cable relative to the cable pulleys which carry or guide the cable,
**characterized in that**
each proximity switch (1) has several different local influence areas (3) and several signal outputs.

2. Circuit as claimed in claim 1, wherein each proximity switch (1) has one control input (6) and one control output (7) and the control output (7) of the (n - 1)th proximity switch (1) is connected to the control input (6) of the n-th proximity switch (1).

3. Circuit as claimed in claim 2, wherein the control input (6) of the first proximity switch (1) is connected to the control output (8) of the control and evaluation unit (2) and the control output (7) of the n-th proximity switch (1) is connected to the control input (9) of the control and evaluation unit (2) and thus a signal line is formed from the control output (8) via the n proximity switches (1) to the control input (9) of the control and evaluation unit (2).

4. Circuit as claimed in one of claims 1 to 3, wherein the proximity switches (1) are addressable and the proximity switches (1) and the control and evaluation unit (2) form a ring with respect to the interrogation and addressing possibility via the corresponding connecting lines (10).

5. Circuit as claimed in claim 4, wherein the addresses and information are transmitted via the connecting lines (10) only in one direction, i.e. opposite the transmission direction of the safety-relevant signals on the signal line.

6. Circuit as claimed in one of claims 1 to 5, wherein each proximity switch (1) has at least three different influence areas (3a, 3b, 3c) and at least three signal outputs.

7. Circuit as claimed in one of claims 1 to 6, wherein each proximity switch (1) has at least one influence area (3a) which is itself divided into two component areas (3a', 3a"), the subdivision into the two component areas (3a', 3a") running perpendicular to the division into the influence areas (3).

8. Circuit as claimed in claim 7, wherein both the lateral slippage of the monitored cable (4) relative to the cable pulleys (5) which guide the cable (4) and also a change of the cable location perpendicular thereto are monitored and detected.

## Revendications

1. Configuration de circuit pour contrôler l'état sans défauts et/ou pour détecter un état défectueux d'une installation de téléphérique ou de télésiège, avec une pluralité n de détecteurs de proximité par exemple, inductifs ou capacitifs, et avec au moins une unité de commande et d'évaluation (2), les détecteurs de proximité (1) étant montés ensemble en série et avec l'unité de commande et d'évaluation (2) et pouvant être interrogés quant à leur état, en particulier quant à leur état de commutation, et contrôlant la position du câble (4) par rapport aux poulies (5) guidant ou portant le câble (4),
**caractérisée en ce que,**
chaque détecteur de proximité (1) présente plusieurs zones d'influence spatialement différentes (3) et plusieurs sorties de signal.

2. Configuration de circuit selon la revendication 1, **caractérisée en ce que** chaque détecteur de proximité (1) présente une entrée de commande (6) et une sortie de commande (7) et la sortie de commande (7) du (n-1)-ième détecteur de proximité (1) est connectée à l'entrée de commande (6) du n-ième détecteur de proximité (1).

3. Configuration de circuit selon la revendication 2, **caractérisée en ce que** l'entrée de commande (6) du premier détecteur de proximité (1) est connectée à la sortie de commande (8) de l'unité de commande et d'évaluation (2) et la sortie de commande (7) du n-ième détecteur de proximité (1) est connectée à l'entrée de commande (9) de l'unité de commande et d'évaluation (2) et ainsi une ligne de signal partant de la sortie de commande (8) est formée par l'intermédiaire des n détecteurs de proximité (1) jusqu'à l'entrée de commande (9) de l'unité de commande et d'évaluation (2).

4. Configuration de circuit selon l'une quelconque des revendications 1 à 3, **caractérisée en ce que** les détecteurs de proximité (1) peuvent être adressés et les détecteurs de proximité (1) et l'unité de commande et d'évaluation (2) quant à la possibilité d'interrogation et d'adressage, forment un anneau par l'intermédiaire de lignes de connexion (10) correspondantes.

5. Configuration de circuit selon la revendication 4, **caractérisée en ce que** les adresses et informations sont transmises par les lignes de connexion (10) seulement dans un sens, et effectivement en sens inverse de la transmission des signaux relevant de la sécurité, sur la ligne de signal.

6. Configuration de circuit selon l'une quelconque des revendications 1 à 5, **caractérisée en ce que** chaque détecteur de proximité (1) présente au moins trois différentes zones d'influence (3a, 3b, 3c) et au moins trois sorties de signal.

7. Configuration de circuit selon l'une quelconque des revendications 1 à 6, **caractérisée en ce que** chaque détecteur de proximité (1) présente au moins une zone d'influence (3a), laquelle en elle-même est divisée à nouveau en deux zones partielles (3a', 3a"), la subdivision en les deux zones partielles (3a', 3a") se prolongeant perpendiculairement à la subdivision dans les zones d'influence (3).

8. Configuration de circuit selon la revendication 7, **caractérisée en ce que**, aussi bien un glissement latéral du câble contrôlé (4) par rapport aux poulies guidant le câble (4) qu'une modification de la position du câble perpendiculairement à celles-ci, est contrôlé et détecté.
